# EUROPEAN PATENT APPLICATION

(11) **EP 2 383 793 A1**
(43) Date of publication of application: **02.11.2011**
(21) Application number: 11003456.8
(22) Date of filing: 27.04.2011
(51) Int. Cl.: H01L 31/0392, C03C 3/083, C03C 3/085, C03C 3/087, C03C 3/091, C03C 3/093

(54) **Solar cell**

(30) Priority: 28.04.2010 JP 2010104062
(71) Applicant: Asahi Glass Company, Limited, Chiyoda-ku Tokyo 100-8405 (JP)
(72) Inventor: Nagashima, Tatsuo, Tokyo 100-8405 (JP); Watanabe, Toshinari, Tokyo 100-8405 (JP); Kiroki, Yuichi, Tokyo 100-8405 (JP)
(74) Representative: Müller-Boré & Partner Patentanwälte

(57) **Abstract**

The present invention provides a solar cell having high photovoltaical conversion efficiency and being excellent in the light transmissivity and weather resistance such as solarization resistance. The present invention relates to a solar cell comprising a double tube composed of two glass tubes differing in the diameter and a photovoltaic conversion layer formed between the two glass tubes, the double tube being sealed at both ends of a part in which the photovoltaic conversion layer is formed, wherein at least one of the two glass tubes is composed of a glass comprising, in mass% based on the oxides, from 60 to 75% of SiO_{2,} from 4 to 10% of Al₂O₃, from 0 to 5% of B₂O₃, from 0 to 5% of MgO, from 0.5 to 5% of CaO, from 0 to 0.5% of SrO, from 0 to 11 % of BaO, from 10 to 16% of Na₂O, from 0 to 10% of K₂O, and from 0.5 to 10% of ZrO₂.

## Description

The present invention relates to a solar cell in which a photovoltaic conversion layer is formed between glass tubes of a double glass tube, typically, a compound thin-film solar cell in which a photovoltaic conversion layer mainly composed of Group 11, 13 and 16 elements is formed on an inside glass tube (inner tube).

Group 11-13 and Group 11-16 compound semiconductors having a chalcopyrite crystal structure or cubic or hexagonal Group 12-16 compound semiconductors have a large absorption coefficient for light in the wavelength range from visible to near infrared, and therefore, they are expected as a material for high-efficiency thin-film solar cells. Representative examples thereof include a Cu(In,Ga)Se₂-based one (hereinafter referred to as CIGS-based one) and a CdTe-based one.

In the CIGS-based thin-film solar cell, a soda lime glass which is inexpensive and has a thermal expansion coefficient close to that of the CIGS-based compound semiconductor, has been studied as the substrate to obtain the solar cell.

Also, for obtaining high efficiency solar cells, a high heat resistance glass has been proposed (see, Patent Document 1).

In addition, a solar cell using a double glass tube has been also proposed (see, Patent Document 2). This solar cell is configured such that a CIGS-based thin film is formed on the outer side of an inner tube and protected by an outside glass tube (outer tube) and the end parts are air-tightly sealed. As for the glass tube of soda lime glass, there has been proposed, for example, glass for annular fluorescent lamps, which does not reduce the lighting efficiency and exhibits good thermal processing (see, Patent Document 3), but this is not necessarily optimal as a double glass tube for solar cells used outdoors.

Patent Document 1: JP-A-11-135819
Patent Document 2: U.S. Patent Application Publication No. 2008/0110491, description
Patent Document 3: JP-B-63-16348

In the case of the above-described solar cell using a double glass tube, it may be considered to use a tube glass of a soda lime glass type (composition in mass%: 70% of SiO₂, 2% of Al₂O₃, 17% of Na₂O, 2% of K₂O, 3% of MgO, 6% of CaO) employed for fluorescent tubes, because this glass is inexpensive and has a thermal expansion coefficient close to that of the CIGS-based compound semiconductor. However, as described later, different characteristics are required of the inner tube and the outer tube, respectively, and the glass for fluorescent tubes can be hardly said to be optimal in terms of any of required characteristics.

An absorption layer of the CIGS-based solar cell is formed on the outer side of the inner tube, and the glass for the inner tube is required to withstand a high temperature, because, as disclosed in Patent Document 1, a heat treatment at a high temperature is preferred for preparing high efficiency solar cells. However, the glass composition having a relative high annealing temperature, which is proposed in Patent Document 1, is a material unsuited for forming of tube glass in view of its viscosity characteristics at high temperatures. On the other hand, the glass for annular fluorescent lamps, which is proposed in Patent Document 3, is a material incapable of withstanding the above-described heat treatment at a high temperature due to its too low softening point.

It is also known that at the formation of an absorption layer of a CIGS-based solar cell, when an alkali metal such as Na and K diffuses from the glass substrate, the performance (photovoltaic conversion efficiency) of the absorption layer is enhanced. Accordingly, for manufacturing a solar cell with good photovoltaic conversion efficiency, glass allowing an alkali metal to exhibit appropriate diffusibility, and uniformly diffuse in the plane is demanded.

Meanwhile, in view of use for a solar cell, the glass composition must be a glass composition ensuring relatively high productivity and the high-temperature viscosity thereof is preferably low to a certain extent. That is, the annealing temperature or softening point is preferably high in comparison with the glass for fluorescent lamps, and the viscosity at high temperatures involving melting of glass is preferably not so much raised as compared with the glass for fluorescent tubes.

For the outer tube, first, from the standpoint of enhancing the efficiency of a solar cell, glass having a high transmittance over a wide range, particularly, even on the long wavelength side, is demanded. Furthermore, in view of long-term outdoor use, high weather resistance and insusceptibility to solarization are demanded. In the case of the conventional soda lime glass, depending on the content of Fe₂O₃, high transmittance may not be necessarily obtained on the long wavelength side, and the solarization resistance is also insufficient.

An object of the present invention is to provide a solar cell having a double glass tube structure capable of solving the problems faced when a glass tube composed of the conventional soda lime glass or the glass disclosed in Patent Document 1 is used as the glass of the double tube.

The present invention provides the following solar cell and glass tube for a solar cell.
(1) A solar cell comprising a double tube composed of two glass tubes differing in the diameter and a photovoltaic conversion layer formed between the two glass tubes, the double tube being sealed at both ends of a part in which the photovoltaic conversion layer is formed,
   wherein at least one of the two glass tubes is composed of a glass comprising, in mass% based on the oxides, from 60 to 75% of SiO₂, from 4 to 10% of Al₂O₃, from 0 to 5% of B₂O₃, from 0 to 5% of MgO, from 0.5 to 5% of CaO, from 0 to 0.5% of SrO, from 0 to 11% of BaO, from 10 to 16% of Na₂O, from 0 to 10% of K₂O, and from 0.5 to 10% of ZrO₂.
   Incidentally, for example, the phrase "comprises from 0 to 5% of B₂O₃" means that B₂O₃ is not essential but may be contained in an amount of up to 5%.
(2) The solar cell according to (1), wherein a total content of Al₂O₃ and ZrO₂ in the glass is from 5 to 15%.
(3) The solar cell according to (1) or (2), wherein a content of Fe₂O₃ in the glass is 0.06% by outer percentage or less based on the total of other components (exclusive of Sb₂O₃ in the case where Sb₂O₃ is contained).
(4) The solar cell according to (1), (2) or (3), wherein the glass does not substantially comprise CeO₂.
(5) The solar cell according to any one of (1) to (4), wherein a glass transition temperature Tg of the glass is 530°C or more.
(6) The solar cell according to any one of (1) to (5), wherein an average linear expansion coefficient of the glass at 50 to 300°C is from 70×10⁻⁷ to 110×10⁻⁷/°C.
(7) The solar cell according to any one of (1) to (6), wherein a temperature at which a melt viscosity of the glass is 10² dPa·s is 1,550°C or less.
(8) The solar cell according to any one of (1) to (7), wherein an average transmittance of the glass at a wavelength of 450 to 1,000 nm is 90% or more in terms of thickness of 1 mm.
(9) The solar cell according to any one of (1) to (8), wherein a transmittance of the glass at a wavelength of 400 nm is 89% or more in terms of thickness of 1 mm.
(10) The solar cell according to any one of (1) to (9), wherein a density of the glass is 2.6 g/cm³ or less.
(11) The solar cell according to any one of (1) to (10), wherein when the glass is held in a water vapor atmosphere at 120°C under 0.2 MPa for 20 hours, an amount of an alkali metal element deposited on a surface of the glass is 200 nmol/cm² or less.
(12) The solar cell according to any one of (1) to (11), wherein an electrical conductivity of the glass at 300°C is 2×10⁻⁶ S/cm or more.

(13) A glass tube for a solar cell, which is used as at least one of two glass tubes of a solar cell comprising a double tube composed of two glass tubes differing in the diameter and a photovoltaic conversion layer formed between the two glass tubes, the double tube being sealed at both ends of a part in which the photovoltaic conversion layer is formed, and which is composed of a glass comprising, in mass% based on the oxides, from 60 to 75% of SiO₂; from 4 to 10% of Al₂O₃, from 0 to 5% of B₂O₃, from 0 to 5% of MgO, from 0.5 to 5% of CaO, from 0 to 0.5% of SrO, from 0 to 11% of BaO, from 10 to 16% of Na₂O, from 0 to 10% of K₂O, and from 0.5 to 10% of ZrO₂.
(14) The glass tube for a solar cell according to (13), wherein when the glass is held in a water vapor atmosphere at 120°C under 0.2 MPa for 20 hours, an amount of an alkali metal element deposited on a surface of the glass is 180 nmol/cm² or less.
(15) The glass tube for a solar cell according to (13) or (14), wherein an electrical conductivity of the glass at 300°C is 2×10⁻⁶ S/cm or more.

According to the present invention, the glass tube of a solar cell having a double glass tube structure can be made to satisfy the conditions that the annealing temperature or softening point is high in comparison with the soda lime glass-type tube glass employed for fluorescent lamps and the viscosity at high temperatures involving melting of glass is not so much raised as compared with the soda lime glass-type tube glass.

Also, the transmittance of the glass tube on the long wavelength side can be increased or the solarization resistance can be enhanced.

In the case of the CIGS-based photovoltaic conversion layer, if the amount of an alkali metal diffused into a CIGS film from glass at the formation of the CIGS film is small, this may incur reduction in the photovoltaic conversion efficiency. For enhancing the photovoltaic conversion efficiency, it is preferred to increase the amount of an alkali metal diffused into a CIGS film from glass at the formation of the CIGS film.

The mobility of an alkali metal element in the oxide glass is correlated with the electrical conductivity, and high electrical conductivity is preferred, because the photovoltaic conversion efficiency can be enhanced. According to the present invention, a tube glass having an electrical conductivity of 2×10⁻⁶ S/cm or more can be provided, so that the photovoltaic conversion efficiency can be enhanced.

Also, in the case of the CIGS-based photovoltaic conversion layer, for reducing the thermal stress generated, the average linear expansion coefficient of the inner tube is preferably close to that of the CIGS-based semiconductor material, that is, preferably from 70×10⁻⁷ to 110×10⁻⁷/°C. According to the present invention, an average linear expansion coefficient near 90×10⁻⁷/°C can be obtained.

There is a method where in a solar cell having a double glass tube structure, the inner tube (a glass tube having a smaller diameter) and the outer tube (a glass tube having a larger diameter) are combined by designing different glass compositions for respective tubes, but in view of efficiency of the production facility, it is preferred to develop a composition satisfying simultaneously all characteristics and constitute both the inner tube and the outer tube from one kind of a glass composition. This can be realized by the glass of the present invention.

In addition, when the fining agent for use in the present invention is configured to give glass which does not substantially comprise CeO₂ and comprises, in mass%, from 0.05 to 0.6% of Sb₂O₃, glass having good solarization characteristics is advantageously obtained.

The solar cell of the present invention typically has the structure disclosed in Patent Document 2, the contents of which are incorporated herein by reference. That is, a back plate, a semiconductor junction and a photovoltaic conversion layer having a transparent conductive layer are formed on the outside surface of an inner tube, that is, on the surface opposing an outer tube, and the part between the inner tube and the outer tube, where the photovoltaic conversion layer is formed, is air-tightly sealed after removing oxygen and moisture by a vacuum treatment or the like. Incidentally, the photovoltaic conversion layer is typically a CIGS-based photovoltaic conversion layer.

The transition temperature Tg of the glass of the inner tube or outer tube is preferably 530°C or more. If the transition temperature is less than 530°C, the process temperature, for example, at the formation of a CIGS film, may not be so much elevated and a high efficiency CIGS film may be hardly formed. Tg is more preferably 540°C or more, still more preferably 550°C or more.

The average linear expansion coefficient of glass of the inner tube or outer tube, particularly the inner tube, at 50 to 300°C is preferably from 70×10⁻⁷ to 110×10^{- 7}/°C. If the average linear expansion coefficient is less than 70×10⁻⁷/°C or is more than 110×10⁻⁷/°C, the thermal expansion difference from the CIGS film may become too large and defects such as separation are readily produced. The average linear expansion coefficient is more preferably 80×10⁻⁷/°C or more or 100×10⁻⁷/°C or less.

The density d of the glass of the inner tube or outer tube is preferably 2.6 g/cm³ or less. If the density is more than 2.6 g/cm³, the solar cell module prepared may warp by its own weight or impose a load on the installation site. The density is more preferably 2.5 g/cm³ or less.

The temperature at which the viscosity of the glass of the inner tube or outer tube is 10² dPa·s is preferably 1,550°C or less. If this temperature is more than 1,550°C, defects ascribable to high-temperature melting may be increased and this may cause a problem such as reduction in productivity or shortening of lifetime of the melting furnace. The temperature at which the viscosity is 10² dPa·s is more preferably 1500°C or less, more preferably 1,465°C or less.

Such glass preferred as the inner tube or outer tube can be formed into a tube by a known glass tubing method such as Danner method. That is, the forming of a glass tube is generally performed in the viscosity region of 10³ to 10⁶ dPa·s. Also, the viscosity of glass continuously changes with the temperature change and therefore, when the temperature giving 10² dPa·s becomes high, the forming temperature naturally rises. For example, in the Danner method, a refractory called sleeve is used and when the forming temperature rises, the corrosion speed of the refractory is increased and stable forming cannot be performed. When the temperature giving 10² dPa·s is 1,470°C or less, excessive rise of the forming temperature can be avoided.

The average transmittance of the glass of the inner tube or outer tube, particularly the outer tube, at a wavelength of 450 to 1,000 nm is preferably 90% or more in terms of thickness of 1 mm. If this average transmittance is less than 90%, the efficiency as a solar cell may decrease. The average transmittance is more preferably 91% or more.

The transmittance of the glass of the inner tube or outer tube, particularly the outer tube, at a wavelength of 400 nm is preferably 89% or more in terms of thickness of 1 mm. If this transmittance is less than 89%, the efficiency as a solar cell may decrease or the glass may undergo solarization due to sunlight in a long-term use to decrease the efficiency of the solar cell. The transmittance is more preferably 90% or more.

In the glass of the inner tube or outer tube, particularly, the outer tube, when the glass is held in a water vapor atmosphere at 120°C under 0.2 MPa for 20 hours, the amount of an alkali metal element deposited on the surface of the glass is preferably 200 nmol/cm² or less. If this amount is more than 200 nmol/cm², the weather resistance may be insufficient and long-term reliability in the solar cell application may not be ensured. The amount is more preferably 180 nmol/cm² or less. Also, it is more preferred that the total amount ofNa and K is 200 nmol/cm² or less.

The glass of the inner tube or outer tube, particularly, the outer tube, preferably has an electrical conductivity (at 300°C) of 2×10⁻⁶ S/cm or more, because the amount of an alkali metal diffused into a CIGS film from glass at the formation of the CIGS film is increased and the photovoltaic conversion efficiency is enhanced. The electrical conductivity is more preferably 3×10⁻⁶ S/cm or more, still more preferably 5×10⁻⁶ S/cm or more.

The reasons for limitation of the contents of the glass composition of the inner tube or outer tube are described below. In the following, unless otherwise indicated, mass% of the components in the composition is simply referred to as "%".

SiO₂ is an essential component for glass formation and the content thereof is from 60 to 75%. If the content is less than 60%, the expansion coefficient becomes large or the chemical durability deteriorates. The content is preferably 61 % or more, more preferably 62% or more. Also, if the content is more than 75%, the expansion coefficient becomes small or the high-temperature viscosity (softening point) rises, making the tube formation difficult The content is preferably 72% or less, more preferably 69% or less.

Al₂O₃ is a component for elevating Tg, reducing the density d or enhancing the chemical durability and weather resistance, and is an essential component. The content thereof is from 4 to 10%. If the content is less than 4%, the chemical durability and weather resistance deteriorate. The content is preferably 4.2% or more, more preferably 4.5% or more. If the content is more than 10%, the viscosity rises to cause inhomogeneous melting and this may give rise to increase of the striae defect or deterioration of the devitrification property. Also, the amount of an alkali metal diffused into a CIGS film from glass at the formation of the CIGS film may decrease and a reduction in the photovoltaic conversion may be incurred. The content is preferably 9% or less, more preferably 8% or less, still more preferably 7% or less.

B₂O₃ is not an essential component but may be contained in an amount of up to 5% for the purpose of, for example, reducing the density or enhancing the meltability. If the content is more than 5%, the expansion coefficient may become small or the amount of an alkali metal diffused into a CIGS film from glass at the formation of the CIGS film may decrease to incur a reduction in the photovoltaic conversion efficiency. The content is preferably 3% or less, more preferably 2% or less. In the case where B₂O₃ is contained, the amount thereof is preferably 0.1% or more for the purpose of obtaining the effect achieved by the addition of B₂O₃.

MgO is not an essential component but may be contained in an amount of up to 5% for the purpose of, for example, enhancing the chemical durability or reducing the density. If the content is more than 5%, the glass is highly likely to be devitrified or the amount of an alkali metal diffused into a CIGS film from glass at the formation of the CIGS film may decrease to incur a reduction in the photovoltaic conversion efficiency. The content is preferably 4% or less, more preferably 3% or less. In the case where MgO is contained, the amount thereof is preferably 0.1 % or more for the purpose of obtaining the effect achieved by the addition of MgO.

CaO is a component for the purposed of, for example, elevating Tg or decreasing the high-temperature viscosity, and is an essential component. The content thereof is from 0.5 to 5%. If the content is less than 0.5%, the high-temperature viscosity is not sufficiently lowered and the meltability is deteriorated. The content is preferably 1% or more, more preferably 2% or more. On the other hand, if the content is more than 5%, the glass is highly likely to be devitrified or the amount of an alkali metal diffused into a CIGS film from glass at the formation of the CIGS film may decrease. Also, Ca ion is close in the ionic radius to Na ion that is believed to compensate for a defect in the CIGS film, and may inhibit the Na effect to incur a reduction in the photovoltaic conversion efficiency. The content is preferably 4% or less.

SrO is not an essential component but may be contained in an amount of up to 0.5% for the purpose of, for example, lowering the high-temperature viscosity or adjusting the expansion coefficient. If the content is more than 0.5%, the amount of an alkali metal diffused into a CIGS film from glass at the formation of the CIGS film may decrease. Also, Sr ion is close in the ionic radius to Na ion that is believed to compensate for a defect in the CIGS film, and may inhibit the Na effect to incur a reduction in the photovoltaic conversion efficiency. Typically, this component is preferably not contained.

BaO is not an essential component but may be contained in an amount of up to 11% for the purpose of, for example, reducing the high-temperature viscosity or adjusting the expansion coefficient while maintaining the diffusion amount of an alkali metal. If the content is more than 11%, Tg may decrease, the density may increase, or bubble cutting in the melting process may become unsuccessful. The content is preferably 10% or less, more preferably 9.5% or less. In the case where BaO is contained, the amount thereof is preferably 0.1 % or more for the purpose of obtaining the effect achieved by the addition of BaO.

Incidentally, in the case of attaching importance to elevating of the process temperature and enhancement of the formation efficiency of CIGS film, the glass transition temperature Tg is preferably higher. In this case, the content of BaO is preferably 5% or less, more preferably 4% or less, still more preferably 3% or less.

Na₂O is a component for contributing to enhancement of the conversion efficiency of a CIGS-based solar cell and is an essential component. The content thereof is from 10 to 16%. Na is known to diffuse into the absorption layer of a CIGS-based solar cell constructed on glass and enhance the conversion efficiency, but if the content is less than 10%, this gives rise to insufficient diffusion ofNa into the absorption layer of a CIGS-based solar cell on the glass and the conversion efficiency may also become insufficient The content is preferably 10.5% or more, more preferably 11% or more, still more preferably 12% or more.

If the Na₂O content is more than 16%, Tg decreases, the expansion coefficient becomes large or the chemical durability deteriorates. The content is preferably 15.5% or less, more preferably 15% or less, still more preferably 14% or less.

K₂O is not an essential component but may be contained in an amount of up to 10% for adjusting the expansion coefficient or viscosity or because this component is expected to, similarly to Na, diffuse into an absorption layer of a CIGS-based solar cell and produce an effect of enhancing the conversion efficiency. If the content is more than 10%, the chemical durability may deteriorate. The content is preferably 6% or less, more preferably 4% or less. In the case where K₂O is contained, the amount thereof is preferably 0.1% or more for the purpose of obtaining the effect achieved by the addition of K₂O.
ZrO₂ is a component for elevating Tg or enhancing the chemical durability and weather resistance, and is an essential component The content thereof is from 0.5 to 10%. If the content is less than 0.5%, Tg may decrease or the chemical durability and weather resistance may deteriorate. The content is preferably 1% or more, more preferably 1.5% or more. If the content is more than 10%, the specific gravity is increased or the devitrification property may deteriorate. The content is preferably 5% or less, more preferably 4% or less.

The total amount of Al₂O₃ and Zr₂O is preferably 5% or more. If this total amount is less than 5%, the chemical durability and weather resistance may deteriorate. The total amount is more preferably 6% or more. If the total amount is more than 15%, the devitrification property may deteriorate. The total amount is preferably 12% or less, more preferably 8% or less.

CeO₂ may cause a reduction in the transmittance of the glass, particularly, of the outer tube or may deteriorate the solarization characteristics and therefore, it is preferred that CeO₂ is not substantially contained.
The content of Sb₂O₃ as a fining agent is preferably from 0.05 to 0.6% by outer percentage based on the total amount of the glass components (exclusive of Fe₂O₃ and CeO₂).

At least one glass of the inner tube and the outer tube is preferably essentially composed of the above-described components but may comprise other components typically in a total amount of 5% or less within the range not impairing the object of the present invention. Incidentally, in the present invention, the phrase "essentially composed of the above-described components" allows it to comprise unavoidable impurities other than the components above. Also, in view of cost and productivity, the inner tube and the outer tube are preferably formed using the same composition.
Depending on the case, ZnO, TiO₂ Li₂O, WO₃, Nb₂O₅, V₂O₅, Bi₂O₃, MoO₃, P₂O₅, F₂ and the like may be contained for the purpose of improving, for example, weather resistance, meltability, devitrification property and ultraviolet protection.

Incidentally, Fe₂O₃ is unavoidably contained as an impurity usually attributable to raw materials and the like, and the content thereof is typically 0.005% by outer percentage or more based on the total amount of the glass components. However, if the content is more than 0.06%, the transmittance lowers and the efficiency of the solar cell decreases. For this reason, the content is preferably 0.06% or less. The content of Fe₂O₃ is more preferably 0.04% by outer percentage or less, still more preferably 0.03% by outer percentage or less, based on the total amount of the glass components.

### Examples

Raw materials were mixed to obtain glass having a composition shown in percent by mass in the columns from SiO₂ to CeO₂ of Tables 1 to 5 and used as the glass raw material. In the Tables, as for two components of Sb₂0₃ and Fe₂O₃, the content by outer percentage based on the total of other components is shown. Here, Examples 1 to 22, 30 and 32 to 37 are Examples of the present invention, Example 23 is Reference Example, and Examples 24 to 29 and 31 are Comparative Examples.

The glass raw material in an amount giving a mass of 400 g after vitrification was put in a cylindrical bottomed platinum-rhodium crucible having a height of 90 mm and an outer diameter of 70 mm. The crucible was placed in a heating furnace and after heating at 1,600°C for 30 minutes while blowing air having a dew point of 80°C from the side of the heating furnace, the glass raw material inside the crucible was forcedly stirred with a stirrer for 1 hour and thereby melted. Thereafter, stirring was stopped, and the melted glass in the crucible was fining still for 1 hour, followed by casting on a carbon plate and cooling in a annealing furnace. After cooling, the sample was taken out of the annealing furnace and subjected to the following measurements, readings or calculations. The results are shown in Tables 1 to 5.

The elongation of glass when quartz glass as a reference specimen was heated at a rate of 5°C/min from room temperature was measured using a differential thermal dilatometer until reaching the temperature where the glass was softened and elongation was no more observed, that is, the yield point, and the temperature corresponding to the inflection point in the thermal expansion curve was taken as the glass transition temperature Tg (unit: °C). Also, the average linear expansion coefficient α (unit: 10⁻⁷/°C) at 50 to 300°C was calculated in the same manner as in the measurement of Tg above.
The density d (unit: g/cm³) was measured by an Archimedes method.
The viscosity η of the melted glass was measured at 1,450°C, 1,500°C, 1,550°C, 1,600°C and 1,650°C by using a high-temperature rotational viscometer, and based on logη at each temperature, the temperature T2 at which η is 10² dPa·s (the temperature at which logη is 2) was calculated (unit: °C).

Furthermore, both surfaces were mirror-polished to prepare a sample having a thickness of 1 mm for transmittance measurement. The transmittance at a wavelength of 400 to 1,000 nm was measured, and the transmittance T₄₀₀ (unit: %) at 400 nm was read. Also, the average transmittance T_{AV} (unit: %) at 450 to 1,000 nm was calculated.

As an index indicative of the diffusion amount of an alkali metal at the formation of a CIGS film, an electrical conductivity (unit: S/cm) was used, because the mobility of the alkali metal element in the oxide glass is correlated with the electrical conductivity. The electrical conductivity of glass was measured using a DC three-terminal method in accordance with JIS C 2139 (2008) (corresponding to IEC 60093:1980, MOD).
More specifically, the glass was processed into a plate form with a size of 50 mm × 50 mm × 2 mm and on the clean largest surfaces, an Al metal was vacuum-deposited to attach a main electrode and a guard ring electrode to one side and attach a counter electrode to the opposite side. A constant voltage was applied to the electrodes, and the current value at each of 100°C, 200°C, 250°C, 300°C and 350°C was measured and determined. In the column of σ_{300°C} of the Tables, a value obtained by interpolating the electrical conductivity at 300°C from the measured values at respective temperatures above is shown. In the Tables, E-n means 10^{-π}. Specifically, E-5, E-6, E-7 and E-8 mean 10⁻⁵, 10⁻⁶, 10⁻⁷ and 10⁻⁸, respectively.

Weather Resistance Test:
Both surfaces of a glass plate having a thickness of 1 to 2 mm and a size of 4 cm × 4 cm were mirror-polished with cerium oxide and cleaned using calcium carbonate and a neutral detergent, and then the glass plate was placed in a super accelerated life tester (Unsaturated Pressure Cooker EHS-411M, trade name, manufactured by Espec Corp.) and left standing still in a water vapor atmosphere at 120°C under 0.2 MPa for 20 hours. The sample after test and 20 ml of ultrapure water were put in a cleaned plastic bag with a zipper and after dissolving surface deposits by means of an ultrasonic wave cleaner for 10 minutes, the eluted alkali metal element was quantitatively determined by the ICP spectrometry. In this Example, elements except for Na and K were lower than the detection limit and therefore, the amount of an alkali metal element was measured as a total amount of Na and K, which is shown as "Amount of NaK eluted" in the Tables. The elution amount was converted into mol and normalized with the surface area of the sample. In the Tables, the unit of numerical values is nmol/cm².
In Tables 1 to 5,"-" indicates that the measurement was not performed.

In Examples 1 to 22, and 33 to 37 which are Examples of the present invention, the glass has relatively low T2 while having α close to that of CIGS and exhibiting Tg of 530°C or more and can satisfy both high heat resistance near the CIGS process temperature and high productivity. Also, the transmittance at a wavelength of 400 nm is sufficiently high, and this suggests that the solarization characteristics are also sufficient. Furthermore, the electrical conductivity σ_{300°C} takes a value of 2.0×10⁻⁶ S/cm or more, and this enables estimating an increase in the diffusion amount of an alkali metal at the formation of a CIGS film and expecting enhancement of the photovoltaic conversion efficiency.

In Examples 30 and 32 which are Examples of the invention, because the content of BaO is 8% or more, the density is relatively high, the Tg is slightly low and less than 530°C, and the process temperature at the formation of a CIGS film cannot be so much elevated, but the diffusion amount of alkali metal is sufficiently ensured and glass enhanced in the photovoltaic conversion efficiency can be expected.

In Example 23 which is Reference Example where MgO and CaO are not contained, the value of σ_{300°C} is large and this suggests that movement of alkali is inhibited by MgO and CaO. However, the glass has low Tg and high T2 because no CaO is contained, and thus, the glass is not applicable to usage of the present invention when attaching importance to Tg and T2.

On the other hand, in Examples 24, 25 and 28 which are Comparative Examples where the content of Al₂O₃ is less than 4% and the total amount of Al₂O₃ and ZrO₂ is less than 5%, the weather resistance is deteriorated. The glass of Example 25 comprises CaO in an amount of 5% or more and is reduced in the electrical conductivity and therefore, a high efficiency CIGS film is difficult to be formed.

In Example 27 which is Comparative Example, the glass is glass for PDP substrate (see, Japanese Patent No. 3731281) and has high Tg but also has high T2, and thus high productivity as tube glass cannot be expected. Furthermore, the glass comprises 5% or more of CaO and the content of Na₂O is less than 10%, implying that the electrical conductivity is low and the diffusion amount of an alkali metal at the formation of a CIGS film is reduced. Therefore, a high efficiency CIGS film is difficult to be formed.
In Example 26 which is also Comparative Example where the glass comprises 0.5% or more of SrO, the electrical conductivity is low and the formation of a high efficiency CIGS film is expected to be difficult.
In Example 29 which is Comparative Example where the content of ZrO₂ is less than 0.5%, the process temperature at the formation of a CIGS film cannot be so much elevated due to Tg of less than 500°C, and a high efficiency CIGS film is difficult to be formed. In Example 31 which is Comparative Example where CeO₂ is contained, the transmittance at a wavelength of 400 nm is 88.6% and insufficient solarization characteristics are expected, leading to a reduction in the efficiency of a solar cell.

**Table 1**

| | Ex. 1 | Ex. 2 | Ex. 3 | Ex. 4 | Ex.5 | Ex.6 | Ex. 7 | Ex.8 |
|---|---|---|---|---|---|---|---|---|
| SiO₂ | 68.4 | 67.8 | 67.5 | 68.0 | 69.2 | 69.5 | 67.7 | 68.3 |
| Al₂O₃ | 5.6 | 5.7 | 5.7 | 5.7 | 5.7 | 5.7 | 5.6 | 5.7 |
| B₂O₃ | 1.1 | 1.1 | 1.1 | 1.1 | 1.1 | 1.1 | 1.0 | 1.0 |
| MgO | 0.9 | 1.9 | 1.6 | 1.9 | 2.3 | 1.9 | 0.9 | 1.9 |
| CaO | 1.7 | 3.6 | 3.1 | 3.6 | 4.5 | 3.6 | 1.8 | 3.1 |
| SrO | 0.0 | 0.0 | 0.0 | 0.0 | 0.0 | 0.0 | 0.0 | 0.0 |
| BaO | 0.0 | 0.0 | 0.0 | 0.0 | 0.0 | 0.0 | 0.0 | 0.0 |
| ZrO₂ | 3.8 | 2.9 | 3.9 | 2.4 | 1.2 | 1.4 | 5.0 | 2.7 |
| Na₂O | 12.6 | 14.0 | 15.8 | 14.0 | 13.0 | 13.6 | 14.6 | 13.5 |
| K₂O | 5.9 | 3.0 | 1.3 | 3.3 | 3.0 | 3.2 | 3.4 | 3.8 |
| CeO₂ | 0.0 | 0.0 | 0.0 | 0.0 | 0.0 | 0.0 | 0.0 | 0.0 |
| Fe₂O₃ | 0.02 | 0.02 | 0.02 | 0.02 | 0.02 | 0.02 | 0.02 | 0.02 |
| Sb₂O₃ | 0.30 | 0.30 | 0.30 | 0.30 | 0.30 | 0.30 | 0.30 | 0.30 |
| Tg/°C | 532 | 544 | 548 | 537 | 545 | 536 | 541 | 539 |
| α | 92 | 91 | 89 | 92 | 89 | 90 | 92 | 93 |
| Density d | 2.452 | 2.481 | 2.495 | 2.472 | 2.465 | 2.487 | 2.470 | 2.469 |
| T₂/°C | 1548 | 1511 | 1495 | - | 1536 | 1531 | - | - |
| T∧∨/% | - | - | - | - | - | 91.9 | - | - |
| T₄₀₀/% | - | - | - | - | - | 91.5 | - | - |
| σ_{300°C} | - | - | - | - | - | 9.7E-6 | - | - |
| Amount of NaK eluted | - | - | - | - | - | 187 | - | 196 |

**Table 2**

| | Ex.9 | Ex.10 | Ex.11 | Ex. 12 | Ex.13 | Ex. 14 | Ex. 15 | Ex.16 |
|---|---|---|---|---|---|---|---|---|
| SiO₂ | 68.2 | 69.6 | 66.8 | 65.5 | 68.5 | 70.8 | 65.2 | 68.4 |
| Al₂O₃ | 5.6 | 5.7 | 5.5 | 5.4 | 5.7 | 5.6 | 5.6 | 4.8 |
| B₂O₃ | 0.0 | 0.0 | 2.1 | 4.2 | 1.7 | 0.0 | 3.3 | 2.2 |
| MgO | 1.9 | 0.0 | 1.9 | 1.8 | 1.4 | 1.3 | 1.9 | 1.4 |
| CaO | 2.7 | 2.7 | 2.6 | 2.5 | 2.7 | 1.8 | 2.6 | 2.7 |
| SrO | 0.0 | 0.0 | 0.0 | 0.0 | 0.0 | 0.0 | 0.0 | 0.0 |
| BaO | 0.0 | 0.0 | 0.0 | 0.0 | 1.2 | 0.0 | 0.0 | 1.2 |
| ZrO₂ | 3.9 | 4.0 | 3.8 | 3.7 | 2.0 | 3.9 | 3.9 | 2.9 |
| Na₂O | 13.2 | 13.5 | 12.9 | 12.6 | 14.8 | 12.2 | 13.1 | 14.2 |
| K₂O | 4.5 | 4.5 | 4.4 | 4.3 | 2.0 | 4.4 | 4.4 | 2.2 |
| CeO₂ | 0.0 | 0.0 | 0.0 | 0.0 | 0.0 | 0.0 | 0.0 | 0.0 |
| Fe₂O₃ | 0.00 | 0.00 | 0.00 | 0.00 | 0.02 | 0.00 | 0.00 | 0.02 |
| Sb₂O₃ | 0.30 | 0.30 | 0.30 | 0.30 | 0.30 | 0.30 | 0.30 | 0.30 |
| Tg/°C | 544 | 540 | 553 | 558 | 534 | 538 | 554 | 542 |
| α | 91 | 91 | 90 | 88 | 90 | 86 | 91 | 88 |
| Density d | 2.502 | 2.493 | 2.513 | 2.522 | 2.513 | 2.475 | 2.524 | 2.520 |
| T₂/°C | - | - | - | - | 1515 | - | - | 1508 |
| T_{AV}/% | - | - | - | - | 91.9 | - | - | 91.9 |
| T₄₀₀/% | - | - | - | - | 91.5 | - | - | 91.3 |
| σ_{300°C} | 2.4E-5 | - | - | - | - | - | - | - |
| Amount of NaK eluted | - | - | - | - | - | - | - | - |

**Table 3**

| | Ex. 17 | Ex.18 | Ex.19 | Ex. 20 | Ex. 21 | Ex.22 | Ex. 23 | Ex. 24 |
|---|---|---|---|---|---|---|---|---|
| SiO₂ | 69.3 | 68.3 | 67.0 | 66.9 | 66.6 | 64.4 | 71.5 | 69.8 |
| Al₂O₃ | 4.9 | 5.2 | 5.5 | 5.4 | 5.7 | 5.5 | 5.9 | 1.7 |
| B₂O₃ | 2.2 | 2.2 | 2.2 | 2.2 | 2.2 | 2.2 | 0.0 | 0.9 |
| MgO | 1.4 | 1.1 | 1.6 | 1.4 | 2.3 | 1.7 | 0.0 | 3.1 |
| CaO | 2.7 | 2.2 | 3.1 | 2.6 | 4.5 | 3.3 | 0.0 | 6.2 |
| SrO | 0.0 | 0.0 | 0.0 | 0.0 | 0.0 | 0.0 | 0.0 | 0.0 |
| BaO | 1.2 | 1.4 | 1.2 | 2.2 | 0.0 | 4.8 | 0.0 | 0.4 |
| ZrO₂ | 2.0 | 2.4 | 2.5 | 2.5 | 2.0 | 1.9 | 4.1 | 0.0 |
| Na₂O | 14.3 | 14.2 | 13.8 | 13.7 | 14.4 | 14.0 | 13.8 | 16.6 |
| K₂O | 2.0 | 3.0 | 3.1 | 3.1 | 2.3 | 2.2 | 4.7 | 1.3 |
| CeO₂ | 0.0 | 0.0 | 0.0 | 0.0 | 0.0 | 0.0 | 0.0 | 0.0 |
| Fe₂O₃ | 0.02 | 0.02 | 0.02 | 0.02 | 0.02 | 0.02 | 0.00 | 0.04 |
| Sb₂O₃ | 0.30 | 0.30 | 0.30 | 0.30 | 0.30 | 0.30 | 0.30 | 0.00 |
| Tg/°C | 537 | 532 | 541 | 535 | 544 | 533 | 517 | 532 |
| α | 87 | 89 | 91 | 90 | 91 | 91 | 89 | 101 |
| Density d | 2.503 | 2.513 | 2.526 | 2.536 | 2.514 | 2.587 | 2.461 | 2.509 |
| T₂/°C | 1500 | - | - | - | 1505 | 1526 | 1621 | 1387 |
| T_{AV}/% | 92 | - | - | - | - | - | - | 91.9 |
| T₄₀₀/% | 91.4 | - | - | - | - | - | - | 91.4 |
| σ_{300°C} | - | - | - | 1.1E-5 | - | - | 4.0E-5 | - |
| Amount of NaK Eluted | - | - | - | - | 27 | 34 | - | 892 |

**Table 4**

| | Ex. 25 | Ex. 26 | Ex. 27 | Ex. 28 | Ex. 29 | Ex. 30 | Ex. 31 | Ex. 32 |
|---|---|---|---|---|---|---|---|---|
| SiO₂ | 70.5 | 67.6 | 60.9 | 71.9 | 71.0 | 66.2 | 63.2 | 64.0 |
| Al₂O3 | 3.7 | 5.7 | 9.5 | 1.7 | 5.9 | 5.4 | 4.8 | 5.3 |
| B₂O₃ | 0.9 | 1.1 | 0.0 | 1.1 | 0.0 | 0.0 | 1.1 | 0.0 |
| MgO | 2.6 | 2.3 | 5.0 | 2.6 | 2.0 | 0.9 | 2.5 | 0.6 |
| CaO | 5.2 | 4.5 | 6.1 | 5.1 | 2.8 | 1.7 | 4.8 | 0.8 |
| SrO | 0.0 | 3.3 | 1.6 | 0.0 | 0.0 | 0.0 | 6.6 | 0.0 |
| BaO | 2.0 | 0.0 | 0.0 | 0.0 | 0.0 | 8.2 | 0.0 | 9.1 |
| ZrO₂ | 0.0 | 0.0 | 2.5 | 1.0 | 0.0 | 1.9 | 1.9 | 3.6 |
| Na₂O | 12.3 | 14.2 | 4.9 | 13.4 | 13.7 | 13.6 | 13.1 | 12.4 |
| K₂O | 2.8 | 1.3 | 9.5 | 3.1 | 4.6 | 2.1 | 1.2 | 4.2 |
| CeO₂ | 0.0 | 0.0 | 0.0 | 0.0 | 0.0 | 0.0 | 0.8 | 0.0 |
| Fe₂O₃ | 0.02 | 0.04 | 0.00 | 0.02 | 0.00 | 0.02 | 0.04 | 0.00 |
| Sb₂O₃ | 0.00 | 0.30 | 0.00 | 0.30 | 0.30 | 0.30 | 0.00 | 0.30 |
| Tg/°C | 526 | 543 | 640 | 530 | 497 | 510 | 579 | 508 |
| α | 90 | 91 | 85 | 92 | 98 | 92 | 92 | 95 |
| Density d | 2.505 | 2.510 | 2.550 | 2.469 | 2.470 | 2.613 | 2.607 | 2.644 |
| T₂/°C | 1486 | 1471 | 1602 | 1463 | - | 1514 | 1406 | - |
| T_{AV}/% | 92.0 | 91.8 | - | - | - | 91.7 | 91.4 | - |
| T₄₀₀/% | 91.5 | 91.1 | - | - | - | 91.5 | 88.6 | - |
| σ_{300°C} | 4.0E-7 | 1.1E-6 | 2.0E-8 | - | - | - | - | - |
| Amount of NaK eluted | 238 | 26 | - | 385 | - | - | 13 | - |

**Table 5**

| | Ex.33 | Ex.34 | Ex. 35 | Ex.36 | Ex. 37 |
|---|---|---|---|---|---|
| SiO₂ | 67.8 | 65.6 | 66.9 | 66.5 | 65.2 |
| Al₂O₃ | 5.7 | 5.6 | 4.2 | 4.1 | 4.1 |
| B₂O₃ | 0.0 | 0.0 | 0.0 | 0.0 | 0.0 |
| MgO | 2.6 | 2.0 | 2.3 | 2.3 | 2.0 |
| CaO | 5.0 | 3.8 | 4.4 | 4.4 | 3.8 |
| SrO | 0.0 | 0.0 | 0.0 | 0.0 | 0.0 |
| BaO | 0.0 | 4.8 | 4.8 | 4.8 | 4.8 |
| ZrO₂ | 2.4 | 2.3 | 2.3 | 2.3 | 4.2 |
| Na₂O | 14.2 | 13.7 | 12.6 | 11.6 | 13.7 |
| K₂O | 2.3 | 2.2 | 2.5 | 4.0 | 2.2 |
| CeO₂ | 0.0 | 0.0 | 0.0 | 0.0 | 0.0 |
| Fe₂O₃ | 0.02 | 0.02 | 0.02 | 0.02 | 0.02 |
| Sb₂O₃ | 0.30 | 0.30 | 0.30 | 0.30 | 0.30 |
| Tg/°C | 547 | 530 | 534 | 532 | 536 |
| α | 90 | 92 | 89 | 92 | 91 |
| Density d | 2.511 | 2.581 | 2.580 | 2.578 | 2.613 |
| T₂/°C | 1514 | 1494 | 1496 | 1504 | - |
| T_{AV}/% | - | - | - | - | - |
| T₄₀₀/% | - | - | - | - | - |
| σ_{300°C} | - | 2.5E-6 | 2.1E-6 | - | - |
| Amount of NaK eluted | 21 | 27 | 32 | 29 | 24 |

While the invention has been described in detail and with reference to specific embodiments thereof, it will be apparent to one skilled in the art that various changes and modifications can be made therein without departing from the spirit and scope of the invention.
This application is based on Japanese Patent Application No. 2010-104062 filed on April 28, 2010, the contents of which are incorporated herein by reference.

According to the present invention, the glass tube of a solar cell, which has a double glass tube structure, can be made to satisfy the conditions that the transition temperature of glass is high in comparison with the soda lime glass-type tube glass employed for fluorescent lamps and the viscosity at high temperatures involving melting of glass is not so much raised as compared with the soda lime glass-type tube glass. Also, the transmittance of the glass tube on the long wavelength side can be increased, the solarization resistance can be improved, and the photovoltaic conversion efficiency of a CIGS solar cell can be enhanced.

## Claims

1. A solar cell comprising a double tube composed of two glass tubes differing in the diameter and a photovoltaic conversion layer formed between the two glass tubes, the double tube being sealed at both ends of a part in which the photovoltaic conversion layer is formed,
wherein at least one of the two glass tubes is composed of a glass comprising, in mass% based on the oxides, from 60 to 75% of SiO₂, from 4 to 10% of Al₂O₃, from 0 to 5% of B₂O₃, from 0 to 5% of MgO, from 0.5 to 5% of CaO, from 0 to 0.5% of SrO, from 0 to 11% of BaO, from 10 to 16% of Na₂O, from 0 to 10% of K₂O, and from 0.5 to 10% of ZrO_{2.}

2. The solar cell according to claim 1, wherein a total content of Al₂O₃ and ZrO₂ in the glass is from 5 to 15%.

3. The solar cell according to claim 1 or 2, wherein a content of Fe₂O₃ in the glass is 0.06% by outer percentage or less based on the total of other components (exclusive of Sb₂O₃ in the case where Sb₂O₃ is contained).

4. The solar cell according to claim 1, 2 or 3, wherein the glass does not substantially comprise CeO₂.

5. The solar cell according to any one of claims 1 to 4, wherein a glass transition temperature Tg of the glass is 530°C or more.

6. The solar cell according to any one of claims 1 to 5, wherein an average linear expansion coefficient of the glass at 50 to 300°C is from 70×10⁻⁷ to 110×10⁻⁷/°C.

7. The solar cell according to any one of claims 1 to 6, wherein a temperature at which a melt viscosity of the glass is 10² dPa·s is 1,550°C or less.

8. The solar cell according to any one of claims 1 to 7, wherein an average transmittance of the glass at a wavelength of 450 to 1,000 nm is 90% or more in terms of thickness of 1 mm.

9. The solar cell according to any one of claims 1 to 8, wherein a transmittance of the glass at a wavelength of 400 nm is 89% or more in terms of thickness of 1 mm.

10. The solar cell according to any one of claims 1 to 9, wherein a density of the glass is 2.6 g/cm³ or less.

11. The solar cell according to any one of claims 1 to 10, wherein when the glass is held in a water vapor atmosphere at 120°C under 0.2 MPa for 20 hours, an amount of an alkali metal element deposited on a surface of the glass is 200 nmol/cm² or less.

12. The solar cell according to any one of claims 1 to 11, wherein an electrical conductivity of the glass at 300°C is 2×10⁻⁶ S/cm or more.

13. A glass tube for a solar cell, which is used as at least one of two glass tubes of a solar cell comprising a double tube composed of two glass tubes differing in the diameter and a photovoltaic conversion layer formed between the two glass tubes, the double tube being sealed at both ends of a part in which the photovoltaic conversion layer is formed, and which is composed of a glass comprising, in mass% based on the oxides, from 60 to 75% of SiO₂, from 4 to 10% of Al₂O₃, from 0 to 5% of B₂O3, from 0 to 5% of MgO, from 0.5 to 5% of CaO, from 0 to 0_{.}5% of SrO, from 0 to 11% of BaO, from 10 to 16% of Na₂O, from 0 to 10% of K₂O, and from 0.5 to 10% of ZrO₂.

14. The glass tube for a solar cell according to claim 13, wherein when the glass is held in a water vapor atmosphere at 120°C under 0.2 MPa for 20 hours, an amount of an alkali metal element deposited on a surface of the glass is 180 nmol/cm² or less.

15. The glass tube for a solar cell according to claim 13 or 14, wherein an electrical conductivity of the glass at 300°C is 2×10⁻⁶ S/cm or more.
